# FASCICULE DE BREVET EUROPEEN

(11) **EP 0 966 474 B1**
(45) Date de publication et mention de la délivrance du brevet: **11.08.2010**
(21) Numéro de dépôt: 98914918.2
(22) Date de dépôt: 13.03.1998
(51) Int. Cl.: C07F 1/08, C23C 16/18

(54) **NOUVEAUX PRECURSEURS DE CUIVRE(I) POUR DEPOT CHIMIQUE EN PHASE GAZEUSE DE CUIVRE METALLIQUE**
KUPFER (I) VORLÄUFER FÜR DIE CHEMISCHE DAMPFPHASENABSCHEIDUNG VON METALLISCHEM KUPFER
NOVEL COPPER(I) PRECURSORS FOR CHEMICAL DEPOSIT IN GAS PHASE OF METALLIC COPPER

(30) Priorité: 13.03.1997 FR 9703029
(43) Date de publication de la demande: 29.12.1999
(73) Titulaire: CENTRE NATIONAL DE LA RECHERCHE SCIENTIFIQUE, 75016 Paris Cédex (FR)
(72) Inventeur: DOPPELT, Pascal,CNRS, F-75231 Paris Cedex 05 (FR)
(74) Mandataire: Novagraaf Technologies
(86) Numéro de dépôt international: PCT/FR1998/000518
(87) Numéro de publication internationale: WO 1998/040387

(56) Documents cités:
- EP-A- 0 070 638

## Description

La présente invention se rapporte à la méthode de dépôt chimique en phase vapeur de métaux purs comme le cuivre et l'argent, dans l'industrie électronique, pour la fabrication de circuits intégrés. Cette méthode désignée CVD pour "Chemical Vapor Deposition" est largement utilisée permet de réaliser à partir de précurseurs desdits métaux sous forme oxydée (+1) les interconnexions et métallisation de circuits intégrés de dimension de 0,25 µm ou moins.

On connait dans l'art antérieur de nombreux précurseurs du cuivre pour l'élaboration de films constitués dudit métal pur. Les précurseurs les plus prometteurs sont des complexes de coordination du cuivre à l'état oxydé (+1) stabilisé par un ligand dans lesquels le cuivre est coordonné à une β-dicétonate, répondant à la formule générale (1) suivante : 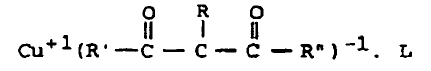 dans laquelle, R, R' et R", identiques ou différents, sont choisis parmi un atome d'hydrogène, un atome d'halogène comme le fluor, un alkyle inférieur éventuellement substitué par un ou plusieurs atomes de fluor.

Des complexes préférés sont dans lesquels R est un atome d'hydrogène et R' et R" sont des alkyles perfluorés et avantageusement des groupes -CF₃. répondant à la formule développée suivant

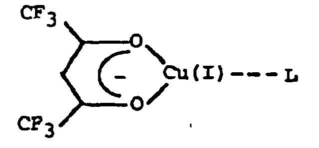

De tels complexes et leur utilisation pour CVD sont décrits par exemple dans les Brevets US No. 5 085 731, 5 096 737, 5 098 516, 5 144 049, 5 187 300, dont l'enseignement sur la méthode CVD est incorporé ici par référence.

Les travaux réalisés sur ces précurseurs montrent que leur structure moléculaire est décisive pour l'obtention reproductible de films de bonne qualité (P. Doppelt et T. H. Baum, MRS Bull. XIX(8) 41, 1994). Toutefois, l'industrie électronique ne dispose pas d'un précurseur idéal pour la fabrication reproductible de circuits électroniques à base de films minces de cuivre permettant le remplissage de lignes et interconnexions verticales sans défaut et avec une faible résistivité et une bonne stabilité thermique à long terme.

Comme rapporté dans les brevets cités ci-dessus, la formation du cuivre métallique est le résultat d'une dismutation de deux molécules de cuivre (I) sur une surface chauffée à une température voisine de 200°C suivant le schéma réactionnel suivant :

2Cu(I) (hfac)L → Cu(II) (hfac)2 + Cu(O) + 2L

La nature de la base de Lewis L, aussi désigné ci-après le ligand, influence très peu la nature des films de cuivre obtenus par CVD. Les films de cuivre sont généralement très purs exempt d'atomes de carbone ou d'oxygène (moins de 1%), et une résistivité de l'ordre de 1,8 µΩ.cm est courrament trouvée dans les films de cuivre obtenus par CVD; cette valeur est très proche de celle trouvée dans le cuivre massif (1,67 µΩ.cm). Par contre la nature du ligand L détermine la volatilité du complexe et en conséquence la vitesse du dépôt de cuivre obtenu.

On connaît dans l'art antérieur plus de 80 complexes de cuivre (I)(hfac) qui ont été testés pour la CVD du cuivre, comme par exemple :
- le monoxyde de carbone, l'isonitrile, les ligands hydrocarbonés unsaturés comportant au moins une insaturation non aromatique, cités dans le brevet US No. 5 098 516;
- les alkynes et dérivés de l'acétylène, les diènes, les oléfines et phosphines, cités dans le brevet US No. 5 096 737;
- les composés cités dans le brevet US 5 144 049 répondant à la formule :

   C(R⁴) (R⁵) = C(R⁵)Si(R⁶)₃

   dans laquelle R⁴, R⁵ et R⁶ sont des atomes d'hydrogènes ou des alkyles inférieurs en C₁ à C₈.
- les composés cités dans le brevet US 5 187 300 répondant à la formule :

   R⁴ - C ≡ C - Si(R⁵)₃

   dans laquelle R⁴ et R⁵ des alkyles inférieurs en C₁ à C₈.

On connait également dans l'état de la technique des complexes de cuivre ou d'argent citées dans le document EP-A-0070638. Les complexes contiennent une dicétone fluoré et des hydrocarbones insaturés comme ligands. Ce document divulgue également des complexes de cuivre avec un ligand qui contient des groupements diphényléthyne ou monophényléthyne.

Les trois précurseurs du cuivre pour CVD, liquides à température ambiante, rapportés dans le tableau I ci-dessous ont été plus particulièrement étudiés.

**Tableau I**

| Précurseurs | Volatilité |
|---|---|
| 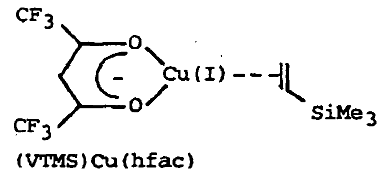 | Très volatil jusqu'à 200 nm/min (H₂O) |
| 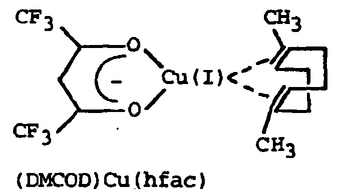 | Peu volatil : 140 nm/min |
| 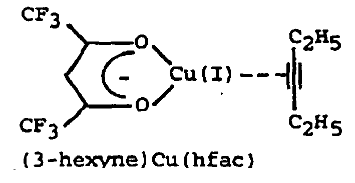 | Très volatil jusqu'à 400 nm/min Formation d'un produit secondaire moins volatil |

Parmi-ceux-ci le complexe (3-hexyne)Cu(hfac) est celui qui donne la vitesse de croissance la plus élevée. Par contre, il a été récemment montré que celui-ci conduit à la formation de complexes dinucléaires qui constituent un obstacle majeur à son utilisation (P. Doppelt et T. H. Baum, Journal of Organometallic Chemistry 517, 53-62, 1996).

Afin de palier cet inconvénient, les inventeurs ont étudié les phénomènes électroniques liés à la formation de complexes dinucléaires lors de l'utilisation d'un complexe du cuivre pour CVD stabilisé par un ligand constitué d'un alcyne substitué ou non. Les travaux de recherche qui ont été réalisés ont permis de montrer que la formation de ces espèces dinucléairs est favorisée lorsque l'alcyne porte des groupements donneurs d'électron, comme par exemple le groupement Si(R)₃ proposé dans le brevet US No. 5 187 300.

La présente invention vise précisément à offrir une solution au problème posé par la formation de complexes dinucléaires lors de l'utilisation d'un complexe du cuivre stabilisé par un ligand du type comportant une triple liaison, tout en conservant les potentialités du précurseur en CVD. Ce but est atteint en utilisant des ligands dans lesquels la triple liaison est partiellement désactivée par un ou deux groupements légèrement attracteur d'électrons comme une double liaion ou un ou deux goupes alkoxy de formule -O-(CH₂)ₙ-CH₃ ou n est 0 jusqu'à de l'orde de 8 et avantageusement un groupe méthoxy (-O-CH₃).

En conséquence, l'invention concerne des complexes organométalliques liquides volatiles ou solides à faible point de fusion, aussi désigné ci-après précurseurs du cuivre (I) pour la déposition chimique en phase vapeur de cuivre, de formule générale (I) : 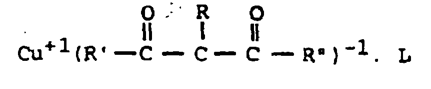 dans laquelle R' et R", identiques ou différents, sont un alkyle en C₁ à C₈ linéaire ou ramifié éventuellement substitué par un ou plusieurs atomes d'halogène comme le fluor, R est choisis parmi un atome d'hydrogène, un atome d'halogène comme le fluor, un alkyne en C₁ à C₈ linéaire ou ramifié éventuellement substitué par un ou plusieurs atomes d'halogène comme le fluor, et L représente le ligand de stabilisation dudit complexe caractérisé en ce que L est un alcyne dont la triple liaison est partiellement désactivée par un ou deux groupements légèrement attracteurs d'électrons portés par le dit alcyne.

Lorsque L est un alcyne dont la triple liaison est partiellement désactivée par deux groupements légèrement attracteurs d'électrons, on préfère que ceux-ci soient disposés de part et d'autre de ladite triple liaison.

Un ligand selon l'invention répond à la formule (II) suivante : 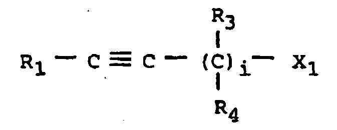 ou à la formule (III) suivante : 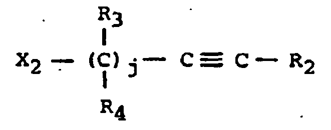 ou à la formule (IV) suivante : 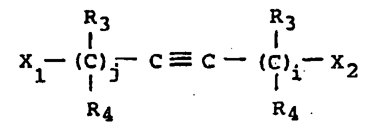 dans lesquelles R₁, R₂, R₃ est R₄ identiques ou différents, son choisis parmi un atome d'hydrogène, un alkyle en C₁ à C₈ linéaire ou ramifié substitué par un ou plusieurs atomes de fluor, et x₁ et x₂ identiques ou différents représentent un groupement légèrement attracteur d'électrons.

Les ligands de l'invention sont des alcène-yne, c'est à dire des composés comprenant une ou deux doubles liaisons et une triple liaison. Ces ligands sont ceux de formules (II), (III) ou (IV) dans lesquelle X₁ et X₂ identiques ou différents sont des radicaux de formule (V) suivante : 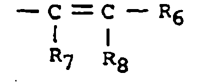 dans laquelle R_{6,} R₇ et R₈ sont choisis parmi un atome d'hydrogène, un alkyle en C₁ à C₈ linéaire ou ramifié substitué par un ou plusieurs atomes d fluor, un groupe Si(R₅)₃ où R₅ est un alkyle en C₁ à C₈ linéaire ou ramifié, ou encore R₆ et R₂ ensemble ou R₆ et R₁ ensemble, ou encore deux radicaux R₆ ensemble, forment un groupe de formule (VI) 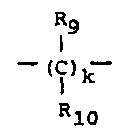 dans laquelle R₉ et R₁₀ sont choisis parmi un atome d'hydrogène, un alkyle en C₁ à C₈ linéaire ou ramifié substitué par un ou plusieurs atomes de fluor, un groupe Si(R₅)₃ où R₅ est un alkyle inférieur, et k est 1 à 3, de façon à former des ligands de formules cycliques, comme par exemple ceux de formule suivante : 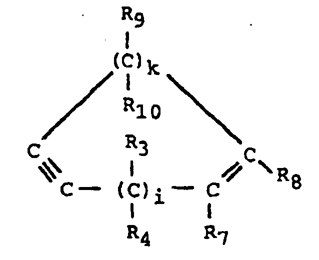 dans laquelle R₃, R₄, R₆, R₇, R₈, R₉, R₁₀, i et k ont la même signification que dans les formules (II), (V) et (VI).

Parmi les composés de formule (IV) dans lesquels X₁ et X₂ sont de formules (V), on préfère ceux dans lesquels i ou j est différent de 0, de façon à éviter la conjugaison des doubles liaisons et de la triple liaison.

Parmi les composés de formules (II) ou (III), On préfère tout particulièrement :
- le 2-méthyl-1-hexen-3-yne de formule : 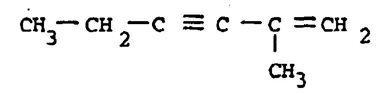
- le 1-héxène-3-yne de formule :

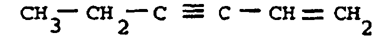

Un second groupe de ligands préférés selon l'invention sont ceux de formules (II), (III) ou (IV) dans lesquelle X₁ et X₂ identiques ou différents sont des radicaux de formule (VII) suivante : 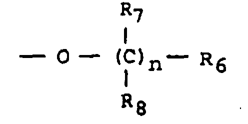 dans laquelle R₆, R₇, R₈ ont la même signification que dans la formule (V), et n est 0 à 8 de façon à ce que (C)ₙ-R₆ demeure un alkyle en C₁ à C₈ linéaire ou ramifié.

Un troisième groupe de ligands selon l'invention sont ceux comprenant à la fois un goupement alkoxy et un groupement comprenant uen double liaison chacun placé de part et d'autre de la double liaison, ces ligands répondent à la formule (IV) dans laquelle X₁ est de formule (V) et X₂ est de formule (VII) ou l'inverse.

Dans les formules ci-dessus, on entend plus particulièrement par alkyle inférieur les alkyles en C₁ à C₈ linéaires ou ramifiés comme -CH3 ou -C2H5. Ceux-ci peuvent être substitués par un ou plusieurs atomes de fluor, comme les radicaux : -CF₃, -C₂F₅, -CH₂CF₃, -CF₂CH₃).

D'autres avantages et caractéristiques de l'invention apparaîtront dans les exemples qui suivent concernant la préparation et l'analyse de complexes du cuivre de formule : 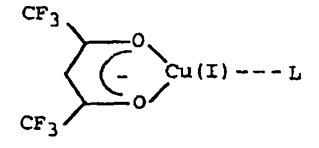 dans laquelle L est le 2-méthyl-1-hexen-3-yne ou le 1-héxène-3-yne, qui sont des composés dont la préparation a déjà été décrite dans l'art antérieur et qui sont connus notamment comme agents de polymérisation.

### Exemple 1:

Le ligand utilisé dans cet exemple est le 2-méthyl-1-hexèn-3-yne disponible dans le commerce. Le complexe du cuivre a été synthétisé par une méthode décrite dans l'art antérieur (P. Doppelt, T. H. Baum et L. Ricard, Inorg. Chem. 35, 1286. 1996). Ses caractéristiques sont les suivantes : Anal. Calculé pour CuC₁₂H₁₁F₆O₂ C, 39.6; H, 3.05; F, 31.32; Cu,17.3. Trouvé : C, 40.0; H, 3.10; Cu 17.0. m.p. = 15°C. IR (liquide entre deux disques de NaCl) : 2983 (f), 2016.3 (f, C≡C), 1671 (m), 1556 (m), 1531 (m), 1490 (s), 1348(f), 1258 (F). 1203 (F), 1147 (F), 1104 (f), 917 (f). 800 (m), 673 (m), 665 (m) . 581 (m), cm⁻¹. ¹H NMR (Bruker, 300 Mhz, CDCl₃, 20°C) : δ 1.34 (t, 9 Hz, CH₃), 2.07 (s, CH₃), 2.71 (q, 9 Hz, CH₂), 5.33 (s, =CH), 5.58 (s, =CH), 6.18 (s, C-H, hfac), ¹³C NMR : δ 13.74 (s, CH₃), 16.24 (s, CH₃). 23.73 (s, CH₂), 87.68 (s, C-H), 89.90 (s, C≡C), 95.76 (s, C≡C). 117.82 (q, 315 MHz, CF₃), 121.54 (s, C=C), 178.12 (q, 32 Hz, C=O).

### Exemple 2 :

Le ligand utilisé dans cet exemple est le 1-hexèn-3-yne qui n'est pas disponible dans le commerce mais dont les caractéristiques sont connues. Ce composé a été préparé en adaptant une méthode décrite dans l'art antérieur (G. Eglinton et M. C. Whiting, J. Org. Chem. 3650 (1950). Le complexe du cuivre a été synthétisé comme dans l'exemple 1, et ses caractéristiques sont les suivantes . m.p. = 18°C. IR (liquide entre deu disques de NaCl) : 2986 (f), 2944 (f), 2885 (tf), 2016.4 (f, C-C), 1641 (m), 1556 (m), 1531 (m), 1472 (s), 1409 (m), 1348 (f), 1257 (F), 1202 (F), 1147 (F). 1102 (f). 967 (f), 800 (m), 673 (m), 589 (m), cm⁻¹. ¹H NMR (Bruker, 300 MHz, CDCl₃, 20°C) δ 1.37 (t, 7.3 Hz, CH₃), 2.67 (qd, 1.5 et 7.5 Hz, CH₂), 5.47 (dd, 1.5 et 10.7 Hz, =CHH), 5.8 (dd, 1.5 et 16.9 Hz, =CHH), 6.05 (ddt, 16.9, 1.5 et 10.7 Hz. =CH, 6.15 (s, C-H, hfac), ¹³C NMR : δ 13.49 (s, CH₃), 16.05 (s, CH₂), 83.72 (s, C≡C), 89.77 (s, C-H), 96.15 (s, C≡C), 112.5 (s, =CH), 117.8 (q, 315 Hz, CF₃), 121.91 (s. C=C), 178.27 (q, 32 Hz, C=O).

### Exemple 3 : analyse des complexes des exemples 1 et 2.

Le spectre rmn du proton permet de déterminer la stochiométrie des complexes en comparant l'intégration des pics du ligand et celui du H methine de l'hexafluoroacéthylacétonate; ce rapport est définitivement 1 ce qui confirme la structure des complexes donnée aux exemples 1 et 2.

Les spectres rmn du ¹³C permettent d'affirmer que le cuivre est lié à la triple liaison par comparaison des pics du ligand libre et du ligand chélaté. Or les nouveaux complexes de l'invention sont bien plus stables que le complexe correspondant où le ligand est le 3-héxyne; en effet, dans ce dernier cas, il a été montré que la triple liaison était capable de chélater des ions (hfac)Cu⁺ donnant un complexe beaucoup moins stable. Avec les complexes de l'invention, la triple liaison est suffisament désactivée, du fait de la conjugaison entre deux insaturations, pour empêcher la formation de complexes binucléaires.

Les complexes des exemples 1 et 2 sont tous deux des liquides jaunes à température ambiante. Ils ont été utilisés avec succès comme précurseurs pour déposer des films de cuivre métallique par CVD. Ils présentent à la fois une bonne volatilité, et en conséquence prmettent réalisent une croissance rapide du film de cuivre, et une grande stabilité à la température d'évaporation. A titre de comparaison, dans le cas du complexe de l'exemple 1. la température du bulleur a été maintenue à 65°C sans dégradation décelable après deux périodes de 12 heures.

## Revendications

1. Complexe de coordination du cuivre à l'état oxydé (+1) stabilisé par un ligand pour la déposition chimique en phase vapeur de cuivre, de formule générale (I) : 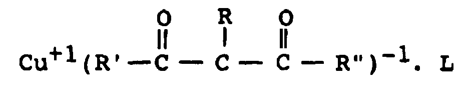 dans laquelle R' et R", identiques ou différents, sont un, alkyle en C₁ à C₈ linéaires ou ramifiés éventuellement substitué par un ou plusieurs atomes d'halogène comme le fluor, R est choisis parmi un atome d'hydrogène, un atome d'halogène comme le fluor, un alkyle en C₁ à C₈ linéaire ou ramifié éventuellement substitué par un ou plusieurs atomes d'halogène comme le fluor, et L représente le ligand de stabilisation dudit complexe, **caractérisé en ce que** L est un alcyne dont la triple liaison est partiellement désactivée par un ou deux groupements légèrement attracteurs d'électrons portés par ledit alcyne et que L répond à la formule (II) suivante : 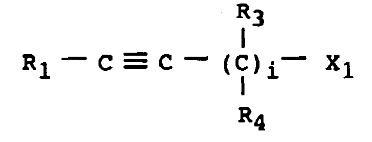 ou à la formule (III) suivante : 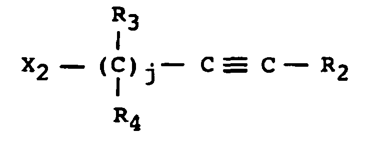 ou à la formule (IV) suivante : 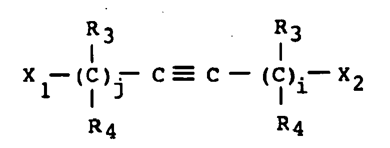 dans lesquelles R₁, R₂, R₃ et R₄ identiques ou différents, sont choisis parmi un atome d'hydrogène, un alkyle en C₁ à C₈ linéaire ou ramifié substitué par un ou plusieurs atomes de fluor, et X₁ et X₂ identiques ou différents représentent un groupement légèrement attracteur d'électrons de formule (V) suivante : 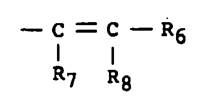 dans laquelle R₆, R₇ et R₈ sont choisis parmi un atome d'hydrogène, un alkyle en C₁ à C₈ linéaire ou ramifié substitué par un ou plusieurs atomes de fluor, un groupe Si(R₅)₃ où R₅ est un alkyle en C₁ à C₈ linéaire ou ramifié, ou encore R₆ et R₂ ensemble ou R₆ et R₁ ensemble, ou encore deux radicaux R₆ ensemble, forment un groupe de formule (VI) suivante 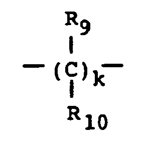 dans laquelle R₉ et R₁₀ sont choisis parmi un atome d'hydrogène, un alkyle en C₁ à C₈ linéaires ou ramifiés substitué par un ou plusieurs atomes de fluor, un groupe Si(R₅)₃ où R₅ est un alkyle en C₁ à C₈ linéaire ou ramifié, et k est 1 à 3, de façon à former des ligands de formules cycliques. -

2. Complexe de coordination du cuivre selon la revendication 1, **caractérisé en ce que** le ligand L répond à la formule (IV) dans laquelle X₁ et X₂ sont de formules (V) et i ou j est différent de 0.

3. Complexe de coordination du cuivre selon la revendication 1, **caractérisé en ce que** L est le 2-méthyl-1-hexen-3-yne.

4. Complexe de coordination du cuivre selon la revendication 1, **caractérisé en ce que** L est le 1-héxène-3-yne.

5. Complexe de coordination du cuivre selon la revendication 1, **caractérisé en ce que** ledit ligand répond à l'une des formules (II), (III) ou (IV) dans laquelle X₁ et X₂ identiques ou différents sont des radicaux de formule (VII) suivante : 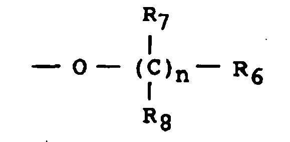 dans laquelle R₆, R₇, R₈ ont la même signification que dans la revendication 1, et n est 0 à 8.

6. Complexe de coordination du cuivre selon la revendication 1, **caractérisé en ce que** ledit ligand répond à la formule (IV) dans laquelle X₁ et X₂ de formules (V) ou (VII) sont différents.

7. Complexe selon l'une quelconque des revendications 1 à 6, **caractérisé en ce que** dans les formules (II), (III), (IV), (V), (VI) et (VII) les alkyles inférieurs sont choisis parmi les alkyles en C₁ à C₈, linéaire ou ramifié, éventuellement substitués par un ou plusieurs atomes de fluor.

8. Procédé pour le dépôt chimique en phase vapeur d'un film de cuivre métallique sur un substrat par contact dudit substrat avec un précurseur de cuivre organométallique volatil en phase vapeur, **caractérisé en ce que** l'on utilise comme dit précurseur un complexe de coordination du cuivre à l'état oxydé (+1) stabilisé par un ligand pour la déposition chimique en phase vapeur de cuivre, de formule générale (I) : 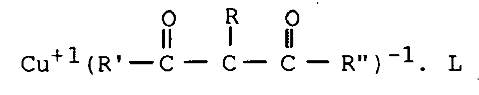 dans laquelle R' et R", identiques ou différents, sont un alkyle en C₁ à C₈ linéaire ou ramifié, éventuellement substitué par un ou plusieurs atomes d'halogène comme le fluor, R est choisis parmi un atome d'hydrogène, un atome d'halogène comme le fluor, un alkyle en C₁ à C₈ linéaire ou ramifié éventuellement substitué par un ou plusieurs atomes d'halogène comme le fluor, et L représente le ligand de stabilisation dudit complexe, **caractérisé en ce que** L est un alcyne dont la triple liaison est partiellement désactivée par un ou deux groupements légèrement attracteurs d'électrons portés par ledit alcyne.

9. Procédé selon la revendication 8, **caractérisé en ce que** le ligand L est un alcyne dont la triple liaison est partiellement désactivée par deux groupements légèrement attracteurs d'électrons disposés de part et d'autre de ladite triple liaison.

10. Procédé selon la revendication 9, **caractérisé en ce que** ledit ligand L répond à la formule (II) suivante : 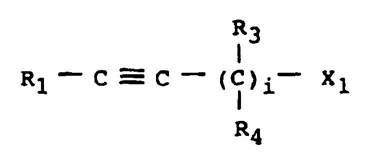 ou à la formule (III) suivante : 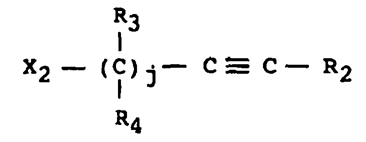 ou à la formule (IV) suivante : 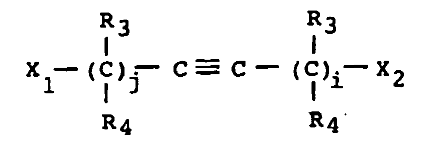 dans lesquelles R₁, R₂, R₃ et R₄ identiques ou différents, sont choisis parmi un atome d'hydrogène, un alkyle en C₁ à C₈ linéaire ou ramifié substitué par un ou plusieurs atomes de fluor, un groupe -Si(R₅)₃ où R₅ est un alkyle en C₁ à C₈ linéaire ou ramifié, i et j sont 0 à 3 et X₁ et X₂ identiques ou différents représentent un groupement légèrement attracteur d'électrons.

11. Procédé pour le dépôt chimique en phase vapeur d'un film de cuivre métallique sur un substrat par contact dudit substrat avec un précurseur de cuivre organométallique volatil en phase vapeur, **caractérisé en ce que** l'on utilise comme dit précurseur de cuivre un complexe de coordination du cuivre selon l'une quelconque des revendications 1 à 7.

## Claims

1. Complex of coordination of oxidised copper (+1) stabilised by a ligand for the gas phase chemical deposit of copper having the general formula (I): 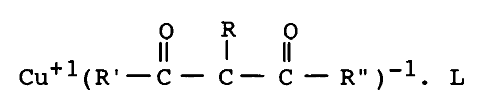 in which R' and R", identical or different, are C1-C8 alkyl linear or branched optionally substituted by one or more halogen atoms, such as fluor, R is chosen from among a hydrogen atom, a halogen atom such as fluor, a C1-C8 alkyl linear or branched optionally substituted by one more halogen atoms such as fluor, and L represents the ligand stabilising said complex, **characterised in that** L is an alkyne of which the triple bond is partially deactivated by one or two groups slightly attracting the electrons carried by said alkyne and L respond to the following formula (II): 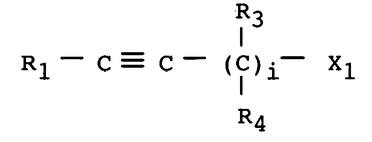 or the following formula (III): 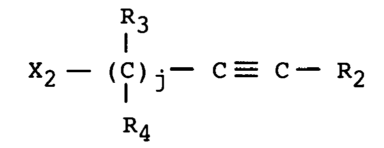 or the following formula (IV): 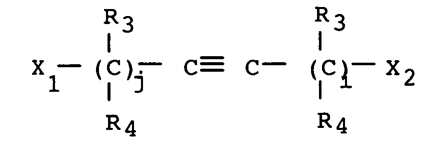 in which R₁, R₂, R₃ and R₄, identical or different, are chosen from among a hydrogen atom, a C₁-C₈ alkyl linear or branched substituted by one or more fluorine atoms, and X₁ and X₂, identical or different, represent a group that is slightly electron-attracting of following formula (V) 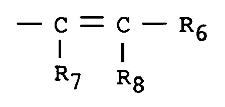 in which R₆, R₇ and R₈ are chosen from among a hydrogen atom, a C₁-C₈alkyl linear or branched substituted by one or more fluorine atoms, a Si(R₅)₃ group in which R₅ is a C₁-C₈ alkyl linear or branched, or in which R₆ and R₂ together or R₆ and R₁ together, or two R₆ radicals together form a group having the following formula (VI): 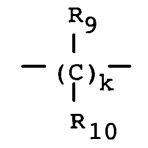 in which R₉ and R₁₀ are chosen from among a hydrogen atom, a C₁-C₈ alkyl linear or branched substituted by one or more fluorine atoms, a Si(R₅)₃ group in which R₅ is a C₁-C₈ alkyl linear or branched, and k is 1 to 3 such as to form ligands having cyclical formulas.

2. Complex of coordination according to claim 1, **characterized in that** the L ligand meets formula (IV) in which X₁ and X₂ are of formula (V) and i or j is different from 0.

3. Complex of coordination according to claim 1, **characterized in that** L is 2-methyl-l-hexen-3-yne.

4. Complex of coordination according to claim 7, **characterized in that** L is 1-hexene-3-yne

5. Complex of coordination of oxidised copper according to claim 1, **characterised** I that said ligand meets one of formulas (II), (III) or (IV) in which X₁ and X₂, identical or different, are radicals of formula (VII) as follows: 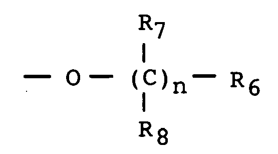 in which R₆, R₇, R₈ have the same denotation as in claim 1, and n is 0 to 8.

6. Complex of coordination of oxidised copper according to claim 1, **characterized in that** said ligand meets formula (IV) in which X₁ and X₂ of formulas (V) or (VII) are different.

7. Complex according to any one of claims 1 to 6, **characterized in that** in formulas (II), (III), (IV), (V), (VI) and (VII) the lower alkyls are chosen from among alkyls at C₁ to C₈, linear or branched optionally substituted by one or fluorine atoms.

8. Method for the gas phase chemical deposit of a metallic copper film on a substrate by contact of said substrate with an organometallic copper precursor volatile in gas phase, **characterised in that** a complex of coordination of oxidised copper (+1) stabilised by a ligand for the gas phase chemical deposit of copper having the general formula (I): 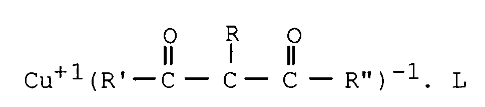 in which R' and R", identical or different, are C1-C8 alkyl linear or branched, optionally substituted by one or more halogen atoms, such as fluor, R is chosen from among a hydrogen atom, a halogen atom such as fluor, a C1 to C8 alkyl linear or branched optionally substituted by one more halogen atoms such as fluor, and L represents the ligand stabilising said complex, **characterised in that** L is an alkyne of which the triple bond is partially deactivated by one or two groups slightly attracting the electrons carried by said alkyne

9. Method according to claim 8, **characterised in that characterised in that** L is an alkyne of which the triple bond is partially deactivated by two groups slightly attracting the electrons carried by said alkyne placed on either side of said triple bond.

10. Method according to claim 9, **characterised in that** said L ligand respond to the following formula (II): 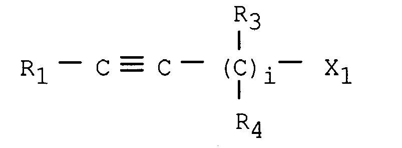 or the following formula (III): 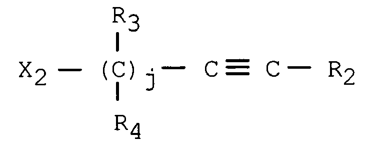 or the following formula (IV): 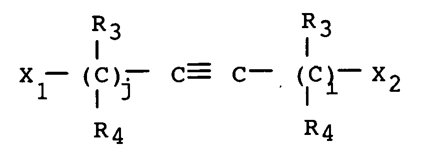 in which R₁, R₂ R₃ and R₄, identical or different, are chosen from among a hydrogen atom, a C₁-C₈ alkyl linear or branched substituted by one or more fluorine atoms, a Si(R₅)₃ group in which R₅ is a C₁-C₈ alkyl linear or branched, i and j are 0 to 3 and X₁ and X₂, identical or different, represent a group that is slightly electron-attracting.

11. Method for the gas phase chemical deposit of a metallic copper film on a substrate by contact of said substrate with an organometallic copper precursor volatile in gas phase, **characterised in that that** a complex of coordination of copper according to any of claims 1 to 7 is used as said precursor.

## Patentansprüche

1. Koordinationskomplex von Kupfer in oxidiertem Zustand (+1), der für die chemische CVD-Abscheidung durch einen Liganden stabilisiert wird, mit folgender allgemeiner Formel (I): 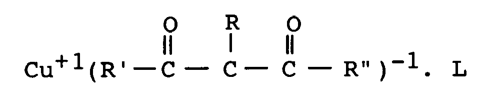 wobei identische oder unterschiedliche R' und R" lineare oder verzweigte C1-C8 Alkyle sind, die gegebenenfalls durch ein oder mehrere Halogenatome wie Fluor substituiert werden, wobei für R ein Wasserstoffatom, ein Halogenatom wie Fluor, ein lineares oder verzweigtes C1-C8 Alkyl, das gegebenenfalls durch ein oder mehrere Halogenatome wie Fluor substituiert wird, gewählt werden und L den Liganden zur Stabilisierung des besagten Komplexes darstellt, **dadurch gekennzeichnet, dass** L ein Alkin ist, dessen Dreifachbindung teilweise durch ein oder zwei Gruppen desaktiviert wird, die schwach Elektronen anziehen, die von dem besagten Alkin getragen werden und L folgender Formel (II) entspricht: 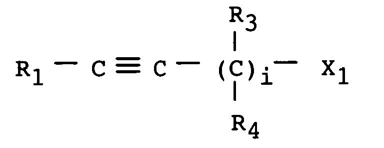 oder folgender Formel (III): 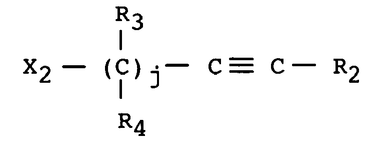 oder folgender Formel (IV): 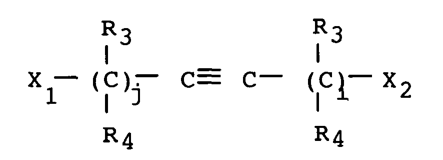 in der für identische oder unterschiedliche R₁, R₂, R₃ und R₄, ein Wasserstoffatom, ein lineares oder verzweigtes C₁-C₈ Alkyl, das durch ein oder mehrere Fluoratome substituiert wird, gewählt werden und identische oder unterschiedliche X₁ und X₂ eine schwach Elektronen anziehende Gruppe mit folgender Formel (V) bilden 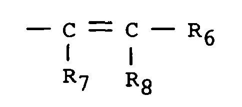 in der für R₆, R₇ und R₈ ein Wasserstoffatom, ein lineares oder verzweigtes C₁-C₈ Alkyl, das durch ein oder mehrere Fluoratome substituiert wird, eine Si(R₅)₃ Gruppe gewählt werden, in der R₅ ein lineares oder verzweigtes C₁-C₈ Alkyl ist, oder in der R₆ und R₂ zusammen, oder R₆ und R₁ zusammen, oder zwei R₆ Radikale zusammen eine Gruppe mit folgender Formel (VI) bilden: 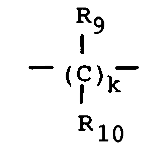 in der für R₉ und R₁₀ ein Wasserstoffatom, ein lineares oder verzweigtes C₁-C₈ Alkyl, das durch ein oder mehrere Fluoratome substituiert wird, eine Si(R₅)₃ Gruppe gewählt werden, in der R₅ ein lineares oder verzweigtes C₁-C₈Alkyl ist, und k gleich 1 bis 3 ist, so dass Liganden mit zyklischen Formeln gebildet werden.

2. Koordinationskomplex von Kupfer gemäss Anspruch 1, **dadurch gekennzeichnet, dass** der Ligand L der Formel (IV) entspricht, in der X₁ und X₂ die Formel (V) aufweisen und i oder j ungleich 0 ist.

3. Koordinationskomplex von Kupfer gemäss Anspruch 1, **dadurch gekennzeichnet, dass** L ein 2-Methyl-1-Hexen-3-yne ist.

4. Koordinationskomplex von Kupfer gemäss Anspruch 1, **dadurch gekennzeichnet, dass** L ein 1-Hexen-3-yne ist.

5. Koordinationskomplex von Kupfer gemäss Anspruch 1, **dadurch gekennzeichnet, dass** besagter Ligand einer der Formeln (II), (III) oder (IV) entspricht, wobei identische oder unterschiedliche X₁ und X₂ Radikale der nachstehenden Formel (VII) sind: 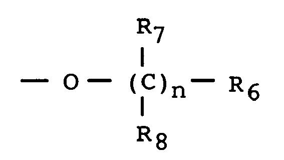 in der R₆, R₇, R₈ die gleiche Bedeutung wie in Anspruch 1 besitzen und n gleich 0 bis 8 ist.

6. Koordinationskomplex von Kupfer gemäss Anspruch 1, **dadurch gekennzeichnet, dass** besagter Ligand der Formel (IV) entspricht, in der X₁ und X₂ der Formeln (V) oder (VII) unterschiedlich sind.

7. Komplex gemäss einem der Ansprüche 1 bis 6, **dadurch gekennzeichnet, dass** in den Formeln (II), (III), (IV), (V), (VI) und (VII) die unteren Alkyle aus linearen oder verzweigten C₁ bis C₈ Alkylen gewählt werden, die gegebenenfalls durch ein oder mehrere Fluoratome substituiert werden.

8. Verfahren zur chemischen Ablagerung eines metallischen Kupferfilms in der Dampfphase auf einem Substrat durch Kontakt des besagten Substrats mit einem in der Dampfphase volatilen organometallischen Kupfervorläufer, **dadurch gekennzeichnet, dass** als besagter Vorläufer ein Koordinationskomplex von Kupfer in oxidiertem Zustand (+1), der durch einen Liganden stabilisiert wird, zur chemischen Ablagerung des Kupfers in der Dampfphase verwendet wird, mit der allgemeinen Formel (I): 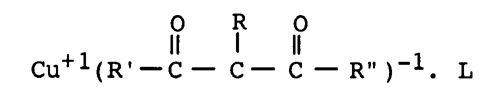 wobei identische oder unterschiedliche R' und R" lineare oder verzweigte C1-C8 Alkyle sind, die gegebenenfalls durch ein oder mehrere Halogenatome wie Fluor substituiert werden, wobei für R ein Wasserstoffatom, ein Halogenatom wie Fluor, ein lineares oder verzweigtes C1-C8 Alkyl, das gegebenenfalls durch ein oder mehrere Halogenatome wie Fluor substituiert wird, gewählt werden und L den Liganden zur Stabilisierung des besagten Komplexes darstellt, **dadurch gekennzeichnet, dass** L ein Alkin ist, dessen Dreifachbindung teilweise durch ein oder zwei Gruppen desaktiviert wird, die schwach Elektronen anziehen, die von dem besagten Alkin getragen werden.

9. Verfahren gemäss Anspruch 8, **dadurch gekennzeichnet, dass** der Ligand L ein Alkin ist, dessen Dreifachbindung teilweise durch zwei Gruppen desaktiviert wird, die schwach Elektronen anziehen, die beiderseits der Dreifachbindung angeordnet sind.

10. Verfahren gemäss Anspruch 9, **dadurch gekennzeichnet, dass** der Ligand L folgender Formel (II) entspricht: 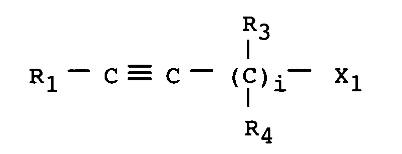 oder folgender Formel (III): 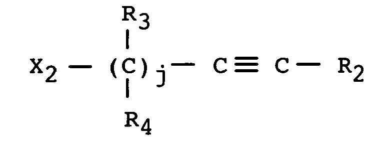 oder folgender Formel (IV): 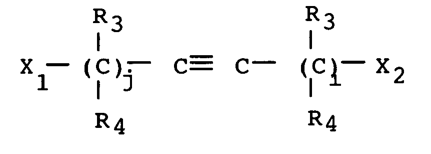 in welchen für identische oder unterschiedliche R₁, R₂, R₃ und R₄, ein Wasserstoffatom, ein lineares oder verzweigtes durch ein oder mehrere Fluoratome substituiertes C₁-C₈ Alkyl, eine Si(R₅)₃ Gruppe gewählt werden, wobei R₅ ein lineares oder verzweigtes C₁-C₈ Alkyl ist, i und j gleich 0 bis 3 sind und identische oder unterschiedliche X₁ und X₂ eine Gruppe darstellen, die schwach Elektronen anzieht.

11. Verfahren zur chemischen Ablagerung eines metallischen Kupferfilms in der Dampfphase auf einem Substrat durch Kontakt des besagten Substrats mit einem in der Gasphase volatilen organometallischen Kupfervorläufer, **dadurch gekennzeichnet, dass** als besagter Vorläufer ein Koordinationskomplex aus Kupfer gemäss einem der Ansprüche 1 bis 7 gewählt wird.
